(19)

Europäisches Patentamt
European Patent Office
Office européen des brevets

(11) **EP 1 860 703 A1**

(12) **EUROPEAN PATENT APPLICATION**

(43) Date of publication:
**28.11.2007 Bulletin 2007/48**

(51) Int Cl.:
*H01L 31/0304* (2006.01)   *H01L 31/0352* (2006.01)
*H01L 31/107* (2006.01)

(21) Application number: **07108665.6**

(22) Date of filing: **22.05.2007**

(84) Designated Contracting States:
**AT BE BG CH CY CZ DE DK EE ES FI FR GB GR HU IE IS IT LI LT LU LV MC MT NL PL PT RO SE SI SK TR**
Designated Extension States:
**AL BA HR MK YU**

(30) Priority: **22.05.2006 JP 2006141989**

(71) Applicant: **Eudyna Devices Inc.**
**Nakakoma-gun, Yamanashi 409-3883 (JP)**

(72) Inventors:
• **Yoneda, Yoshihiro,**
**Eudyna Devices In.c**
**Nakakoma-gun, Yamanashi 409-3883 (JP)**
• **Koyama, Yuji,**
**Eudyna Devices In.c**
**Nakakoma-gun, Yamanashi 409-3883 (JP)**

(74) Representative: **Fenlon, Christine Lesley**
**Haseltine Lake**
**Lincoln House**
**300 High Holborn**
**London WC1V 7JH (GB)**

(54) **Semiconductor light-receiving device with carrier multiplication**

(57)   A semiconductor light-receiving device includes:
a first conduction layer (12) of a first conduction type; a light absorption layer (14) provided on the first conduction layer (12); a multiplication layer (20) provided on the light absorption layer (14); a window layer (40) provided on the multiplication layer (20), the window layer (40) being undoped or having the first conduction type; and a second conduction region (42) provided in the window layer (40) by impurity diffusion, the second conduction region (42) having a band gap wider than that of the light absorption layer (14) and having a second conduction type different from the first conduction type. The following condition is satisfied:

$$r/W \geq (M-1)^2 / (2M)$$

where W is a film thickness from a lower surface of the light absorption layer (14) and an upper surface of the multiplication layer (20), M is a multiplication factor and r is the radius of curvature of the doping profile of the second conduction region (42) so that multiplication is achieved at a voltage below edge-breakdrown sets in.

FIG. 2

EP 1 860 703 A1

**Description**

BACKGROUND OF THE INVENTION

1. Field of the Invention

This invention generally relates to semiconductor light-receiving devices suitably used for optical fiber communication systems, and more particularly, to a photodiode having a multiplication function due to impact ionization.

2. Description of the Related Art

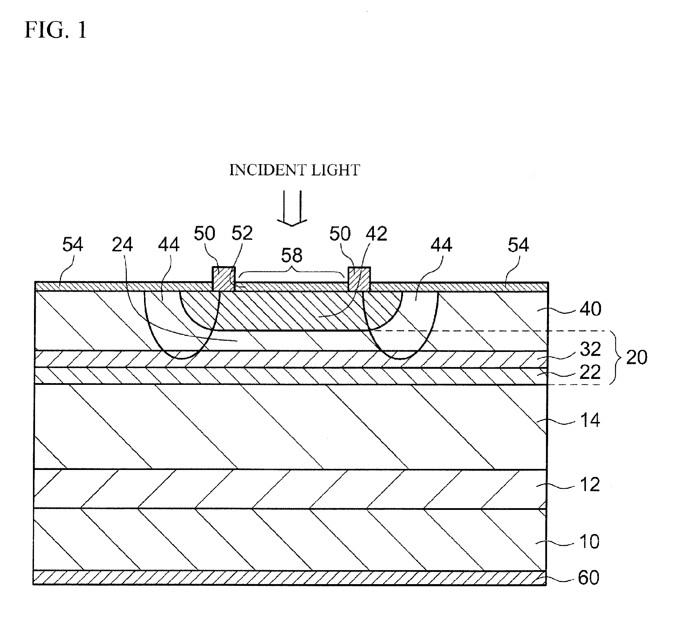

Fig. 1 is a schematic cross-sectional view of a conventional InP/InGaAs avalanche photodiode (APD) used for optical communications (see Japanese Patent Application Publication No. 5-21830). Referring to Fig. 1, there is provided an $n^+$-type InP substrate 10, on which layers 12, 14, 22, 32 and 40 are provided in this order. The layer 12 is an $n^+$-type InP conduction layer, and the layer 14 is an undoped InGaAs light absorption layer 14. The layer 22 is an InGaAsP buffer layer, and the layer 32 is an $n^+$-type InP electric field drop layer. The layer 40 is an InP window layer. An antireflection layer 52 is provided in a light-receiving region 58 on the surface of the InP window layer 40. A p-type contact electrode 50 is provided around the light-receiving region 58. A protection film 54 is formed around the p-type contact electrode 50. A $p^+$-type conduction region 42 is formed within the InP window layer 40 in the light-receiving region 58. A $p^-$-type guard ring region 44, which is deeper than the $p^+$-type conduction region 42, is provided around the $p^+$-type conduction region 42. An n-type contact electrode 60 is provided on the backside of the substrate 10.

An undoped layer 24 is formed within the window layer 40 between the $p^+$-type conduction region 42 and the electric field drop layer 32. The window layer 40 has a band gap greater than that of the light absorption layer 14. Thus, light incident to the light-receiving region 58 passes through the window layer 40 and is then absorbed by the light absorption layer 14. Holes among electron-hole pairs produced in the light absorption layer 14 are injected into a multiplication layer 20, which is interposed between the light absorption layer 14 and the $p^+$-type conduction region 42 due to the reverse biasing applied at the pn junction. The multiplication layer 20 functions to multiply holes (carriers) injected from the light absorption layer 14. The buffer layer 22, which is one of the layers of the multiplication layer 20, functions to reduce the difference in band gap between the light absorption layer 14 and the window layer 40. The band gap of the buffer layer 22 changes continuously. The electric field drop layer 32 is doped to have the $n^+$-type, and drops the electric field in the multiplication layer 20 and the light absorption layer 14. Thus, the holes are accelerated in the electric field drop layer 32, and carrier multiplication takes place in the upper portion of the electric field drop layer 32 and the undoped layer 24, so that the electron-hole pairs can be multiplied. The holes thus multiplied reach the $p^+$-type conduction region 42. A multiplication factor M is defined as a ratio of the number of carriers taken out of the multiplying region to the number of carriers injected to the multiplying region.

Generally, the APD has a planar structure in which the $p^+$-type conduction region 42 is formed by selective diffusion. However, in the planar structure, an edge breakdown takes places in the periphery of the $p^+$-type conduction region 42 prior to a breakdown that takes places at the center of the $p^+$-type conduction region 42. The edge breakdown is more likely to occur as the curvature radius in the periphery of the $p^+$-type conduction region 42 decreases or the slope of impurity concentration increases. The occurrence of the edge breakdown merely results in the flow of current even when the reverse voltage is increased, and hardly increases the reverse voltage at the pn junction of the light-receiving region 58 in the center portion of the $p^+$-type conduction region 42. Thus, the device is no longer capable of exhibiting the function as APD. With the above in mind, the guard ring 44 is provided around the $p^+$-type conduction region 42 in order to make the breakdown voltage in the vicinity of the $p^+$-type conduction region 42 higher than the breakdown voltage in the flat portion (light-receiving region 58) in the center of the $p^+$-type conduction region 42.

The multiplication factor M of the APD for optical communications shown in Fig. 1 is generally up to about 15 in practical use. When the multiplication factor M is increased, the frequency response is restricted and excess noise is increased because of the product of the multiplication factor and the bandwidth (MB product). There is an optimal multiplication factor at which the maximum S/N ratio (minimum receive sensitivity) is available.

Generally, the operating voltage is needed to be as high as at least 50 V for a high multiplication factor. The multiplication factor (output current) varies greatly as the light incident power varies at a high multiplication factor. Thus, the voltage is regulated in practical use so that the multiplication factor (output current) can be kept constant. Thus, the APD is used along with a high voltage power source and a bias voltage control device (driver).

A PIN photodiode (PIN-PD) that does not have carrier multiplication can operate at a low voltage equal to or lower than 20 V, and does not change the photosensitivity (output current) to variations in incident light. Thus, the PIN-PD may be operated at a contact voltage with a simple drive circuit without any voltage control. Thus, the PIN-PD does not need the high voltage power source and the bias voltage control device (driver) necessary for the APD operation.

The structure shown in fig. 1 employs the guard ring 44 provided around the $p^+$-type conduction region 42 in order to avoid the edge breakdown. The guard ring 44 is defined by ordinary diffusion or ion implantation and a subsequent thermal treatment at a significantly high temperature. The guard ring 44 thus defined functions to reduce the slope of impurity concentration at the pn junction. The guard ring 44 directly affects the device reliability. In addition, the guard ring 44 defined through a complicated production process including a huge number of steps. Thus, the APD having the structure shown in Fig. 1 is much more expensive than the PIN-PD. Therefore, the expensive APD is used for backbone systems in the optical communications system and PID photodiode is used for less expensive subscriber systems.

The spread broadband communications environment needs light-receiving devices having high sensitivities for the subscriber systems. Such high sensitivities cannot be theoretically realized by the PID photodiode. It is economically difficult to apply the APD to the light-receiving devices in the subscriber systems that are needed to be less expensive. In addition, the subscriber systems originally suppose the use of PID photodiodes and are thus designed to have a less expensive operating environment with a low voltage or a constant voltage implemented by a simple drive circuit. The subscriber systems do not need a multiplication factor M as high as that for the backbone systems, and cannot drive the APD that needs the high operating voltage. Thus, the subscriber systems may be modified so as to have an expensive power supply environment capable of producing a high voltage.

SUMMARY OF THE INVENTION

The present invention has been made in view of the above circumstances, and provides a semiconductor light-receiving device capable of obtaining a minimum required multiplication factor M prior to the occurrence of edge breakdown. The present semiconductor light-receiving device may operate in a voltage environment similar to that for PIN-PDs.

According to an aspect of the present invention, there is provided a semiconductor light-receiving device including: a first conduction layer of a first conduction type; a light absorption layer provided on the first conduction layer; a multiplication layer provided on the light absorption layer; a window layer provided on the multiplication layer, the window layer being undoped or having the first conduction type; and a second conduction region provided in the window layer by impurity diffusion, the second conduction region having a band gap wider than that of the light absorption layer and having a second conduction type different from the first conduction type, the following condition being satisfied: $X/W \geq (M - 1)^2/ (2M)$ where W is a film thickness from a lower surface of the light absorption layer and an upper surface of the multiplication layer, X is a film thickness of the second conduction region, and M is a multiplication factor.

According to another aspect of the present invention, there is provided a semiconductor light-receiving device including: a first conduction layer of a first conduction type; a light absorption layer provided on the first conduction layer; a multiplication layer provided on the light absorption layer; a window layer provided on the multiplication layer, the window layer being undoped or having the first conduction type; and a second conduction region provided in the window layer by impurity diffusion, the second conduction region having a band gap wider than that of the light absorption layer and having a second conduction type different from the first conduction type, the multiplication layer having an electric field drop layer that contacts the light absorption layer and has a band gap narrower than that of the second conduction region, the electric field drop layer having a cope concentration higher than that of the light absorption layer.

BRIEF DESCRIPTION OF THE DRAWINGS

Preferred embodiments of the present invention will be described in detail based on the following figures, in which:

Fig. 1 is a cross-sectional view of a conventional planar type semiconductor light-receiving device;
Fig. 2 is a cross-sectional view of a semiconductor light-receiving device in accordance with a first embodiment;
Fig. 3 is a schematic view of a pn junction of the semiconductor light-receiving device in accordance with the first embodiment;
Fig. 4 is a cross-sectional view of a semiconductor light-receiving device in accordance with a second embodiment;
Fig. 5 is a graph of a dope concentration as a function of the depth from the surface of the device of the second embodiment;
Fig. 6 is a cross-sectional view of a semiconductor light-receiving device in accordance with a third embodiment;
Fig. 7A is a graph of the band gap as a function of the depth of the device of the first embodiment;
Fig. 7B is a graph of the electric field intensity as a function of the depth of the device of the third embodiment;
Fig. 8A is a graph of the band gap as a function of the depth of the device of the first embodiment;
Fig. 8B is a graph of the electric field intensity as a function of the depth of the device of the third embodiment;
Fig. 9 is a cross-sectional view of a semiconductor light-receiving device in accordance with a fourth embodiment;
Fig. 10 is a cross-sectional view of a semiconductor light-receiving device in accordance with a fifth embodiment;
Fig. 11 is a cross-sectional view of a semiconductor light-receiving device in accordance with a sixth embodiment; and
Fig. 12 is a cross-sectional view of a semiconductor light-receiving device in accordance with a seventh embodiment.

## DESCRIPTION OF THE PREFERRED EMBODIMENTS

[First Embodiment]

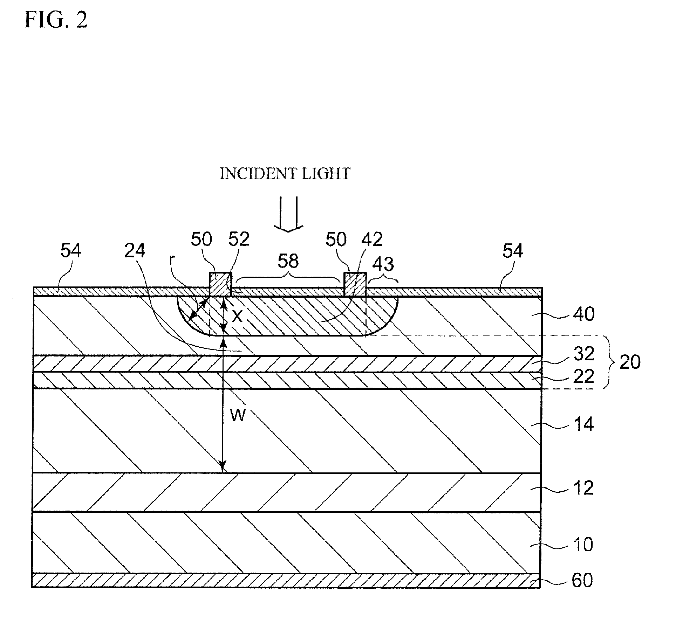

Fig. 2 is a cross-sectional view of a light-receiving device in accordance with a first embodiment of the invention. The first embodiment doest not have any p⁻-type guard ring region used in the conventional APD. Like the structure shown in Fig. 1, the $n^+$-type conduction layer 12 and the window layer 40 have the same band gaps, and the light absorption layer 14 has a band gap narrower than the identical band gaps of the $n^+$-type conduction layer 12 and the window layer 40. The other structures of the device shown in Fig. 2 are the same as corresponding those of the structure shown in Fig. 1.

Now, a description will be given of a condition for obtaining a desired multiplication factor in the multiplication layer 20 in the light-receiving region 58 prior to the occurrence of edge breakdown at edge portions of the $p^+$-type conduction region 42 (arch-shaped portions). The condition is obtained in the following computer simulation.

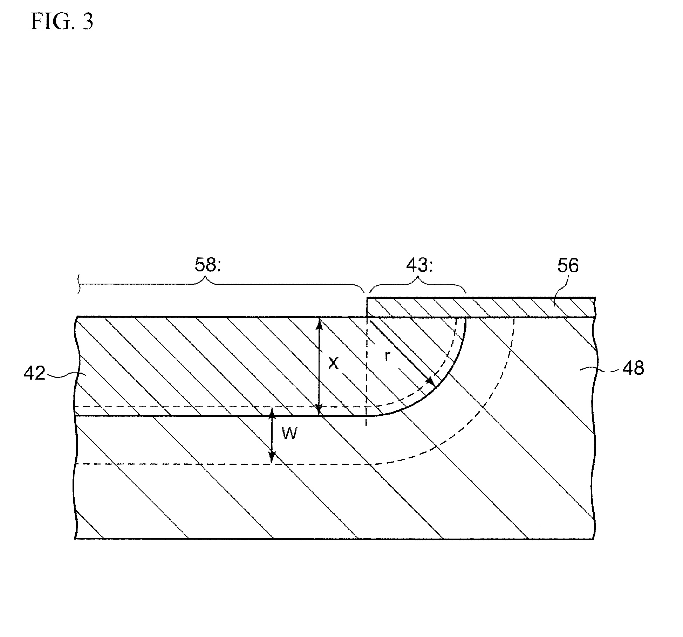

Fig. 3 schematically depicts a mode used in the computer simulation. The $p^+$-type conduction region 42 is formed in an undoped or n⁻-type semiconductor layer (window layer) 48 with a mask 56 for diffusion. A pn junction with a depletion layer width W is formed between the semiconductor layer 48 and the $p^+$-type conduction region 42. The $p^+$-type conduction region 42 is formed by diffusion of p-type dopant with the mask 56 for diffusion. Thus, an edge portion 43 of the $p^+$-type conduction region 42 is formed into an arc shape having a curvature radius r. The curvature radius r may approximately equal to a thickness X of the $p^+$-type conduction region 42. When the above parameters are applied to the structure shown in Fig. 2, the film thickness from the lower surface of the light absorption layer 14 to the upper surface of the multiplication layer 20 is the depletion layer width W of the pn junction, the thickness of the $p^+$-type conduction region 42 is X, and the arc of the edge portion 43 of the $p^+$-type conduction region 42 is r.

In the light-receiving region 58, the following parameters are defined: VB is the voltage at which avalanche breakdown occurs, VD is a built in potential of the pn junction between the $n^+$-type conduction layer 12 and the $p^+$-type conduction region 42, and Vj is a voltage applied between the p-type contact electrode 50 and the n-type contact electrode 60. Further, the following expression is defined: Vb = VD + VJ where Vb is the reverse voltage. The multiplication factor M is described by expression [1]:

$$[1]$$

$$M \doteqdot \frac{1}{1 - \left[ \left| \frac{Vb}{VB} \right| \right]^n}$$

A parameter n depends on the device structure, and is generally equal to 1. Parameter VB is defined by expression [2]:

$$[2]$$

$$VB \doteqdot Vb \cdot \left[ \frac{M}{M-1} \right]$$

A voltage Ve at which the edge breakdown takes place in the edge portion 43 of the $p^+$-type conduction region 42 is defined by expression [3]:

$$[3]$$

$$Ve \doteqdot VB \cdot \left[ \left[ \left[ 2 + \frac{r}{W} \right] \cdot \left[ \frac{r}{W} \right] \right]^{\frac{1}{2}} - \left[ \frac{r}{W} \right] \right]$$

where W is the depletion layer width of the pn junction in the flat portion of the p$^+$-type conduction region 42, and r is the curvature radius of the edge portion 43 of the p$^+$-type conduction region 42.

The condition for obtaining avalanche breakdown in the light-receiving region 58 prior to the occurrence of edge breakdown is defined by expression [4] :

$$[4]$$

$$\frac{Ve}{Vb} \geqq 1$$

Expression [4] can be rewritten into expression [5] using expressions [2] and [3]:

$$[5]$$

$$\left[\frac{M}{M-1}\right] \cdot \left[\left(\left[2+\frac{r}{W}\right] \cdot \left[\frac{r}{W}\right]\right)^{\frac{1}{2}} - \left[\frac{r}{W}\right]\right] \geqq 1$$

From expression [5], the curvature radius r and the depletion layer width W of the pn junction for obtaining an arbitrary multiplication factor M prior to the occurrence of edge breakdown are obtained as expression [6]:

$$[6]$$

$$\left[\frac{r}{W}\right] \geqq \frac{(M-1)^2}{2M}$$

The thin thickness X of the p$^+$-type conduction region 42 formed by impurity diffusion in the window layer 40 is approximately equal to the curvature radius r. By setting the curvature radius r approximately equal to the film thickness X of the p$^+$-type conduction region 42, the curvature radius r can be determined by controlling the film thickness X. Actually, the film thickness deviates from the designed value, the curvature radius r may deviate from the target value. As long as at least the curvature radius r is approximately equal to or greater than the film thickness X, the ratio r/W increases and satisfies expression [6]. Thus, expression [6] can be rewritten into expression [7]:

$$[7]$$

$$\left[\frac{X}{W}\right] \geqq \frac{(M-1)^2}{2M}$$

Expressions [6] and [7] define the condition for the ratio of the curvature radius r of the arc of the edge portion 43 of the p$^+$-type conduction region 42 or the thickness X of the p$^+$-type conduction region 42 to the depletion layer width W of the pn junction in order to obtain an arbitrary multiplication factor M (equal to or greater than 1) required for the semiconductor light-receiving device prior to the occurrence of edge breakdown. In the semiconductor light-receiving device that satisfies expressions [6] and [7], breakdown does not occur before the multiplication factor M required for the device is obtained.

The semiconductor light-receiving device in accordance with the first embodiment includes the n$^+$-type conduction layer 12 (first conduction layer), the light absorption layer 14 provided on the n$^+$-type conduction layer 12, the multiplication layer 20 provided on the light absorption layer 14, and the p$^+$-type conduction region 42 (second conduction region of the conduction type different from that of the first conduction layer) that is provided on the multiplication layer 20 and has a band gap greater than the light absorption layer 14. Since the band gap of the p⁺-type conduction region 42 is greater than that of the light absorption layer 14, the light incident to the light-receiving region 58 reaches the light absorption layer 14. The light that reaches the light absorption layer 14 is absorbed and results in electron-hole pairs under a condition that a reverse bias is applied across the pn junction between the p⁺-type conduction region 42 and the n⁺-type conduction layer 12. The holes (carriers) are accelerated in the multiplication layer 20 towards the p⁺-type conduction region 42, and avalanche multiplication takes place. The multiplied holes (carriers) reach the p⁺-type conduction region 42.

In the above-mentioned structure, the p⁺-type conduction region 42 that satisfies expression [7] makes it possible to obtain a desired multiplication factor M in the multiplication layer 20 in the light-receiving region 58 prior to the occurrence of edge breakdown. Thus, the device of the first embodiment does not need the p⁻-type guard ring 44 used in the conventional APD shown in Fig. 1. Further, the p⁺-type conduction region 42 can be formed so that the peripheral portion of the p⁺-type conduction region 42 located further out than the light-receiving region 58 is gradually thinned towards the edge. Thus, the device of the first embodiment does not need the complicated process for forming the p⁻-type guard ring 44. Further, the production cost can be reduced. In the first embodiment, the depletion layer width W is the total of the thickness of the light absorption layer 14 and that of the multiplication layer 20. In another arrangement in which an undoped layer (for example, an InP layer) is provided between the n⁺-type conduction layer 12 and the light absorption layer 14, the depletion layer width W corresponds to the thickness up to the upper surface of the n⁺-type conduction layer 12.

In order to increase the multiplication factor M, it is required to increase the curvature radius r of the p⁺-type conduction region 42, that is the thickness X of the p⁺-type conduction region 42 to satisfy expression [7]. However, the p⁺-type conduction region 42 is formed by diffusion, and it is thus difficult to increase the thickness X. From viewpoints of fabrication, the ratio r/W is preferably equal to or smaller than 2. When M is equal to or smaller than 6, the ratio r/W is reduced to 2 or smaller, and the diffusion process can be sufficiently controlled. For a high multiplication factor M, the parameter r is increased and W is reduced in order to obtain a large value of the ratio r/W. It is to be noted that the depletion layer width W affects the quantum efficiency (M = 1 with no avalanche multiplication) and frequency response. Thus, increasing the curvature radius r is prioritized while the depletion layer width W is kept unchanged. However, there is a size limit on the curvature radius r in terms of the controllability of diffusion process. Thus, from expression [7], it is preferable to set the multiplication factor M equal to or smaller than 6.

When the multiplication factor M is less than 3, the operating performance of the semiconductor light-receiving device may not be obtained. It is thus preferable to set the multiplication factor M equal to or greater than 3. In order to increase the curvature radius r while the width of the multiplication layer is kept unchanged, it is necessary to thicken at least the window layer 40. Sufficient controllability of diffusion process can be maintained by setting the thickness of the window layer 40 to any value between 0.8 $\mu$m and 6.4 $\mu$m. The curvature radius r can be set approximately equal to the thickness X of the p⁺-type conduction region 42 by setting the carrier concentration of the window layer 40 to an undoped level or a low carrier level equal to or less than $3 \times 10^{15}$ cm⁻³. According to the first embodiment with the simple structure, it is possible to obtain the minimum required multiplication factor M of the semiconductor light-receiving device prior to the occurrence of edge breakdown. Therefore, the first embodiment may be suitably applied to light-receiving devices of the subscriber systems that do not require a high multiplication factor M for the backbone systems but are required to be less expensive. When the semiconductor light-receiving device of the first embodiment is operated with a multiplication factor M of 6 or smaller, the device may be applied to light-receiving devices of the subscriber systems that do not require a high multiplication factor M for the backbone systems but are required to be less expensive.

[Second Embodiment]

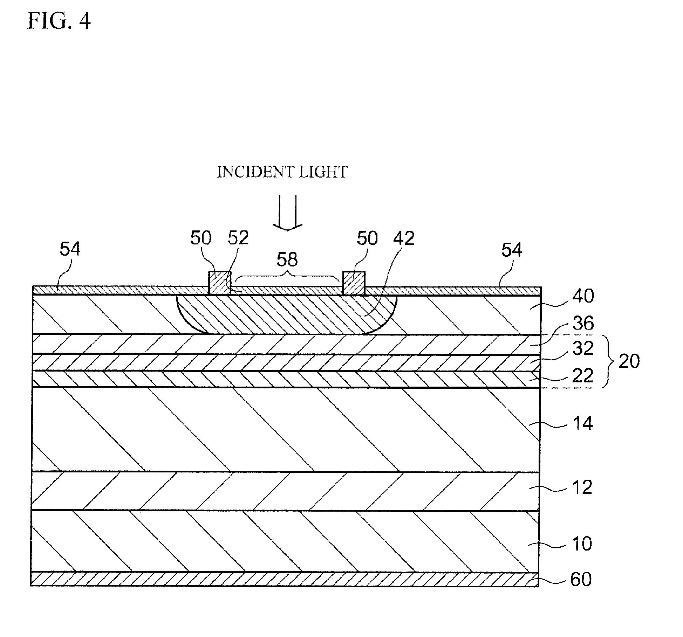

Fig. 4 is a cross-sectional view of a semiconductor light-receiving device in accordance with a second embodiment. An n⁺-type InP dope layer 36 is provided on the electric field drop layer 32 in addition to the structure of the first embodiment shown in Fig. 2. The window layer 40 is provided on the dope layer 36. The p⁺-type conduction region 42 is provided so as to contact the dope layer 36. That is, the thickness of the p⁺-type conduction region 42 is approximately equal to the thickness of the window layer 40. The other structures of the second embodiment are the same as corresponding those of the first embodiment. Therefore, parts that are the same as those shown in the previous figures are given the same reference numerals, and a description thereof will be omitted here.

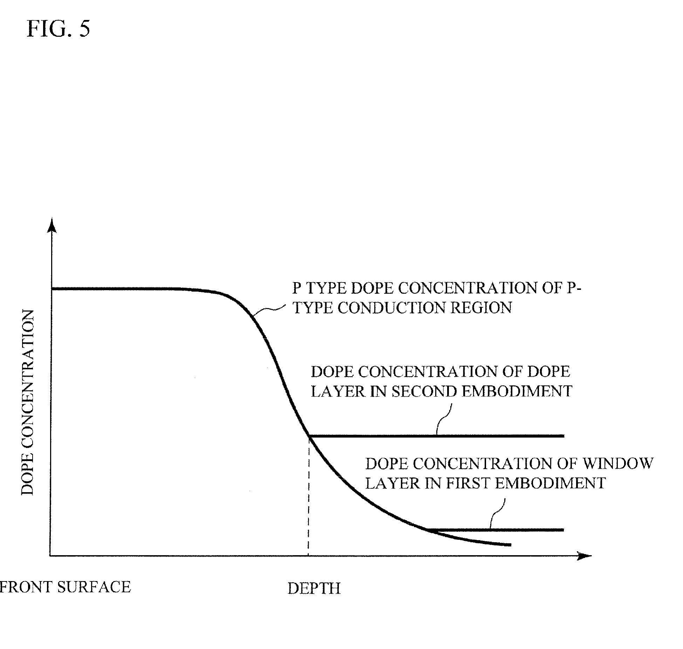

Fig. 5 is a graph that explains advantages of the second embodiment. The horizontal axis of the graph denotes the depth from the surface of the window layer 40, and the vertical axis denotes the dope concentration below the light-receiving region 58. When the p⁺-type conduction region 42 is thickened in order to increase the multiplication factor M, the p-type dope concentration has a skirt shape in a deep region from the surface. In the structure of the first embodiment, the p⁺-type conduction region 42 contacts the undoped window layer 40. Thus, the window layer 40 has a small amount of dose, and the sharpness of the slope of impurity concentration of the pn junction is reduced. Thus, there is increased difficulty in the occurrence of avalanche multiplication, so that the multiplication factor M cannot be increased. According to the second embodiment, the multiplication layer 20 includes the dope layer 36 of the $n^+$-type (first conduction type), which contacts the $p^+$-type conduction region 42 and has a dope concentration higher than that of the light absorption layer 14. Thus, as shown in Fig. 5, the dope concentration of p-type forms the pn junction at a shallow position on the skirt shape. Thus, the pn junction with the sharp slope of the impurity concentration can be formed.

Now, let us consider an exemplary condition that satisfies expression [6] for a multiplication factor M of 6 in the structure of the second embodiment. From expression [6], r/W ≥ 2.08 is obtained. The exemplary specifications of the layers of the second embodiment are as follows. The $n^+$-type InP substrate 10 has an n-type carrier concentration (a silicon dopant, for example) of 2 x $10^{18}$ cm$^{-3}$. The $n^+$-type conduction layer 12 having an n-type carrier concentration of 2 x $10^{18}$ cm$^{-3}$ is formed to a thickness of 1 $\mu$m. The undoped light absorption layer 14 is formed to a thickness of 2 $\mu$m. The undoped i-InGaAsP buffer layer 22 is formed to a thickness of 0.2 $\mu$m. This is an intermediate layer in which the composition changes continuously in the thickness direction. The $n^+$-type InP electric field drop layer 32 having an n-type carrier concentration of 5 x $10^{17}$ cm$^{-3}$ is formed to a thickness of 100 nm. The $p^-$-type InP dope layer 36 having an n-type carrier concentration of 5 x $10^{15}$ cm$^{-3}$ is formed to a thickness of 100 nm. The undoped $n^-$-type InP window layer 40 is formed to a thickness of 5.0 $\mu$m. The above layers may be formed by MOVPE or another crystal growing technique such as MBE.

The pn junction by diffusion is formed at the interface between the $n^-$-type InP dope layer 36 and the undoped $n^-$-type InP window layer 40. Thus, in the second embodiment, the avalanche multiplication starts after the edge of the depletion layer reaches a high concentration layer (the interface between the $n^+$-type conduction layer 12 and the light absorption layer 14) (punch through). From this viewpoint, the depletion layer width W of expression [6] is the sum of the film thicknesses of the light absorption layer 14, the buffer layer 22, the electric field drop layer 32 and the dope layer 36, and is equal to 2.4 $\mu$m. Further, the curvature radius r is, at least, X, that is, the film thickness of the undoped $n^-$-type InP window layer 40, and is equal to 5.1 $\mu$m. Thus, the ratio r/W is equal to 2.13 and the condition defined by expression [6] is satisfied. Thus, it can be concluded that the edge breakdown does not occur in the present semiconductor light-receiving device without the $p^-$-type guard ring 44.

A description will now be given of an exemplary method for fabricating the semiconductor light-receiving device that satisfies the above-mentioned condition. The $n^+$-type InP substrate 10 doped with silicon at 2 x $10^{18}$ cm$^{-3}$ is prepared. The following layers are formed MOVPE or MBE. The $n^+$-type conduction layer 12 doped with silicon at a carrier concentration of 1 x $10^{18}$ cm$^{-3}$ is formed to a thickness of 1 $\mu$m. The undoped light absorption layer 14 of InGaAs is formed to a thickness of 2 $\mu$m. The undoped i-InGaAsP buffer layer 22 is formed to a thickness of 0.2 $\mu$m. This is an intermediate layer in which the composition changes continuously in the thickness direction. The $n^+$-type InP electric field drop layer 32 doped with silicon at a carrier concentration of 5 x $10^{17}$ cm$^{-3}$ is formed to a thickness of 0.1 $\mu$m. The $p^-$-type InP dope layer 36 doped with silicon at a carrier concentration of 5 x $10^{15}$ $_{CM}$$^{-3}$ is formed to a thickness of 100 nm. The undoped $n^-$-type InP window layer 40 is formed to a thickness of 5.1 $\mu$m. A silicon nitride film is formed on the window layer 40 by, for example, CVD as the protection film 54. An opening for diffusion is formed in the protection film 54 in a region corresponding to the light-receiving region 58. With the protection film 54 being used as a mask for diffusion, Cd or Zn is selectively diffused to form the $p^+$-type conduction region 42 that contacts the dope layer 36. The antireflection layer 52 is formed in the light-receiving region. The p-type contact electrode 50, which has a ring shape and a two-layer structure of Au/Zn, is formed around the light-receiving region 58. The n-type contact electrode of AuGe is formed on the backside of the semiconductor substrate 10.

As the film thickness of the $p^+$-type conduction region 42 is increased, the slope of impurity concentration may be decreased because of a skirt shape of the diffusion front of the flat portion. The second embodiment is designed to prevent degradation of the slope of impurity concentration by disposing the dope layer 36 having an impurity concentration higher than that of the window layer 40 and setting the thickness of the window layer 40 equal to the depth X of the $p^+$-type conduction region 42 so that the diffusion front of the pn junction (the center portion of the second conduction region 42) of the light-receiving region 58 coincides with the interface between the window layer 40 and the InP dope layer 36 (the diffusion front is slightly compressed to the dope layer 36). A required multiplication and frequency response performance in the optical fiber communication systems (in the range of 1.27 to 1.62 $\mu$m) can be obtained by setting the film thickness of the InP dope layer 36 to the range of 0.1 $\mu$m to 0.3 $\mu$m and setting the carrier concentration to the range of 5 x $10^{15}$ cm$^{-3}$ and 5 x $10^{16}$ cm$^{-3}$.

In the first and second embodiments, the curvature radius r of the arc of the edge portion 43 of the $p^+$-type conduction region 42 is approximately equal to the thickness X of the $p^+$-type conduction region 42. However, in practice, the curvature radius may deviate from the thickness X. For r > X, r/W becomes greater and still falls within the condition defined by expression [1]. In contrast, r < X, the condition of expression [1] may not be satisfied.

In this case, the material of the mask for diffusion may be changed. For example, the mask 56 for diffusion may be changed. More specifically, the mask 56 for diffusion may be designed to apply stress to the surface of the semiconductor layer 48, and may have a two-layer structure composed of a dielectric film such as a silicon nitride film, and a metal film having a good adhesiveness to the dielectric film such as a Ti/Pt film or a TiW film. It is thus possible to obtain a large diffusion speed in the transverse direction as compared to the mask 56 for diffusion formed by the single dielectric layer. The two-layer mask is removed after the p+-type conduction layer 42, and the protection film 54 is formed.

In the first and second embodiments, the zone from the upper surface of the n+-type conduction layer 12 to the multiplication region adjacent to the lower surface of the p+-type conduction region 42 is depleted in operation, so that the electric field intensity necessary for avalanche multiplication can be obtained.

[Third Embodiment]

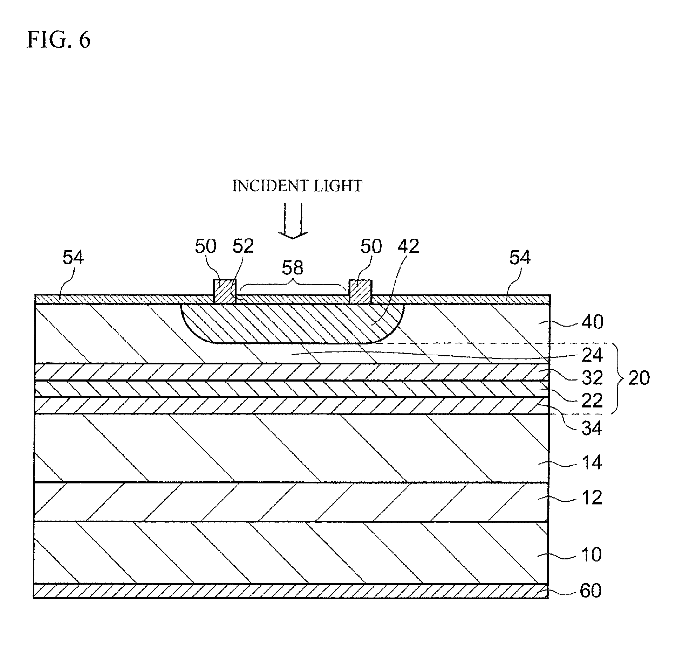

Fig. 6 is a cross-sectional view of a semiconductor light-receiving device in accordance with a third embodiment. An n+-type InGaAs electric field drop layer 34 is provided to the structure of the first embodiment shown in Fig. 2. More specifically, the electric field drop layer 34 is interposed between the light absorption layer 14 and the buffer layer 22 and has a carrier concentration higher than that of the light absorption layer 14. The electric field drop layer 34 may be 0.1 $\mu$m thick and has a dope concentration of $1 \times 10^{16}$cm$^{-3}$. The other structures of the third embodiment are the same as corresponding those of the first embodiment, and a description thereof will be omitted here.

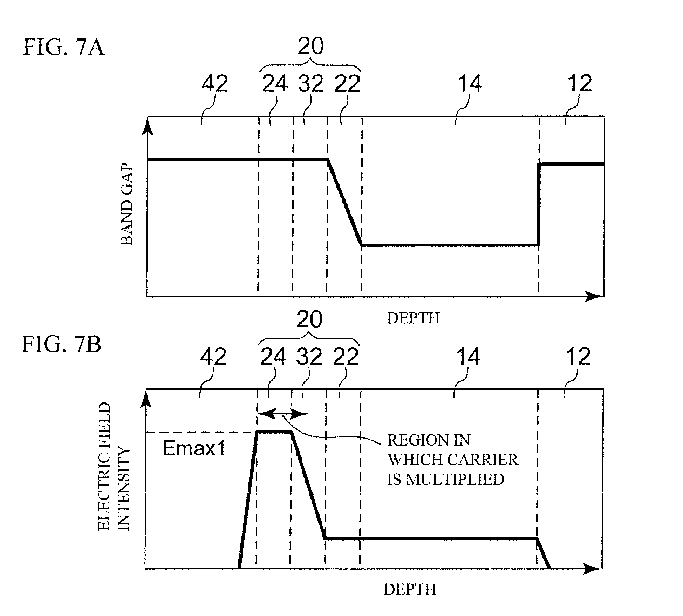

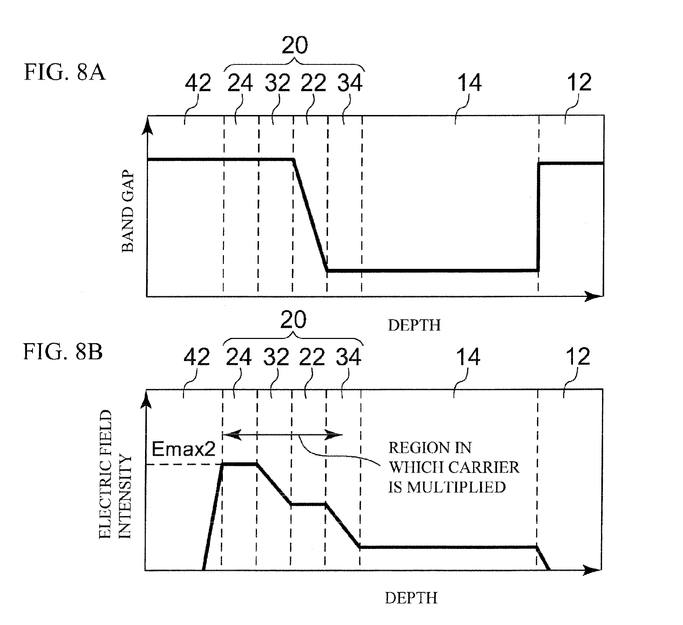

Figs. 7A, 7B, 8A and 8B are schematic graphs for describing effects of the third embodiment as compared to the first embodiment. More particularly, Fig. 7A shows the band gaps of the semiconductor layers as a function of the depth from the surface of the p+-type conduction region 42 in the light-receiving region 58 of the APD of the first embodiment. The APD of the first embodiment has a large band gap because the p+-type conduction region 42, the undoped InP layer 24, the electric field drop layer 32 and the n+-type conduction layer 12 are formed by respective InP layers. The light absorption layer 14 is formed by an InGaAs layer that has a small band gap. The buffer layer 22 has the band gap that continuously changes from the InGaAs layer to the InP layer. Fig. 7B shows the electric field intensity as a function of the depth of the light-receiving region 58 of the APD of the first embodiment when a reverse bias is applied cross the pn junction. Since only the electric field drop layer 32 is doped with the n type in the depletion layer, the electric field mostly changes in the electric field drop layer 32. Thus, the holes (carrier) injected into the multiplication layer 20 from the light absorption layer 14 are accelerated in the electric field drop layer 32. Then, avalanche multiplication takes place in the upper portion of the electric field drop layer 32 and the undoped InP layer 24, and electrons are thus multiplied. The maximum electric field intensity necessary for obtaining the multiplication factor m is now assumed as Emax1.

Fig. 8A shows the band gaps of the semiconductor layers as a function of the depth from the surface of the p+-type conduction region 42 in the light-receiving region 58 of the APD of the third embodiment. The InGaAs electric field drop layer 34 having the same band gap as that of the light absorption layer 14 is provided just above the light absorption layer 14. Fig. 8B shows the electric field intensity as a function of the depth of the light-receiving region 58 of the APD of the third embodiment when a reverse bias is applied cross the pn junction. The present APD has the two electric field drop layers doped with n+-type dopant, the electric field changes in the electric field drop layers 34 and 32. The holes (carrier) injected into the multiplication layer 20 from the light absorption layer 14 are accelerated in the electric field drop layer 34 first, and are accelerated in the electric field drop layer 32. The third embodiment has a wider multiplication region than the first embodiment. Thus, the third embodiment can set the maximum electric field intensity Emax2 less than the maximum electric field intensity Emax1 of the first embodiment for the same multiplication factor M. That is, the reverse bias applied across the pn junction for the same multiplication factor M can be reduced.

In a case where the multiplication factor M is high in the InGaAs layer having a higher impact ionization rate of electrons than that of holes, excessively increased noise and degradation of the dynamic characteristics may take place. In contrast, for a multiplication factor M as low as, for example, 6, increase in nose and degradation of the dynamic characteristics may not be serious. The third embodiment is effective particularly to an operation with a low multiplication factor M.

As described above, the semiconductor light-receiving device of the third embodiment has the multiplication layer 20 designed to have the electric field drop layer 34 that contacts the light absorption layer 14, the layer 34 having a narrower band gap than the p+-type conduction region 42 (second conduction region) and a higher dope concentration than the light absorption layer 14. Since the electric field drop layer 34 contacts the light absorption layer 14, the region for multiplying the carrier can be lengthened. This makes it possible to reduce the voltage applied across the pn junction for the same multiplication factor. The band gap of the electric field drop layer 34 is preferably identical to that of the light absorption layer 14. However, it is enough to set the band gap of the electric field drop layer 34 narrower than that of the p+-type conduction region 42. When the electric field drop layer 34 having the band gap approximately equal to that of the light absorption layer 14, it is preferable to set the film thickness of the electric field drop layer 34 equal to 5 % of the film thickness of the light absorption layer 14 in order to restrain tunnel current.

It is possible to obtain a multiplication factor M of 6 with a voltage equal to or lower than 20 V and operate the APD with a voltage (equal to or lower than 20 V) as low as the operating voltage of the PIN-PD by setting the thickness of the electric field drop layer 34 to the range of 0.1 $\mu$m to 0.3 $\mu$m and setting the carrier concentration to the range of $5 \times 10^{15}$ cm$^{-3}$ and $5 \times 10^{16}$ cm$^{-3}$ .

The multiplication layer 20 may include the electric field drop layer 32 (upper electric field drop layer) that is provided above the electric field drop layer 34 through a layer (buffer layer 22) having a dope concentration lower than that of the layer 34 and has a higher dope concentration than the light absorption layer 14.

By providing the electric field drop layer 34 having an impurity concentration than the light absorption layer 14 closer to the pn junction, it is possible to cause the multiplication function even in the light absorption layer 14. The effective multiplication region can be expanded to a part of the light absorption layer 14, so that multiplication can be caused at a reduced voltage.

[Fourth Embodiment]

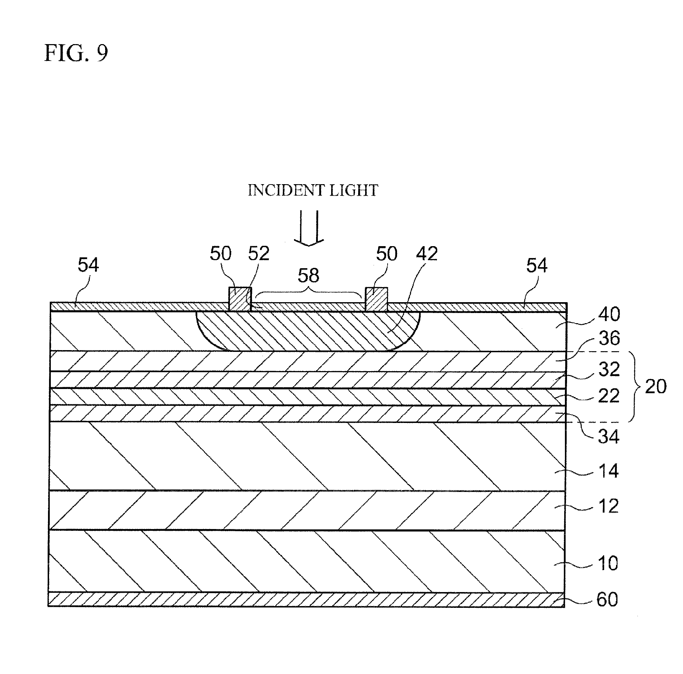

Fig. 9 is a cross-sectional view of a semiconductor light-receiving device in accordance with a fourth embodiment. The fourth embodiment employs the n-type InP dope layer 36 on the electric field drop layer 32 in the third embodiment shown in Fig. 6 as in the case of the second embodiment. That is, the multiplication layer 20 includes the dope layer 36 that contacts the p$^+$-type conduction region and has a higher cope concentration than the light absorption layer 14. The other structures of the fourth embodiments are the same as corresponding those of the third embodiment, and a description thereof will be omitted. According to the fourth embodiment, like the second embodiment, the sharp pn junction can be obtained in addition to the advantages of the third embodiment.

[Fifth Embodiment]

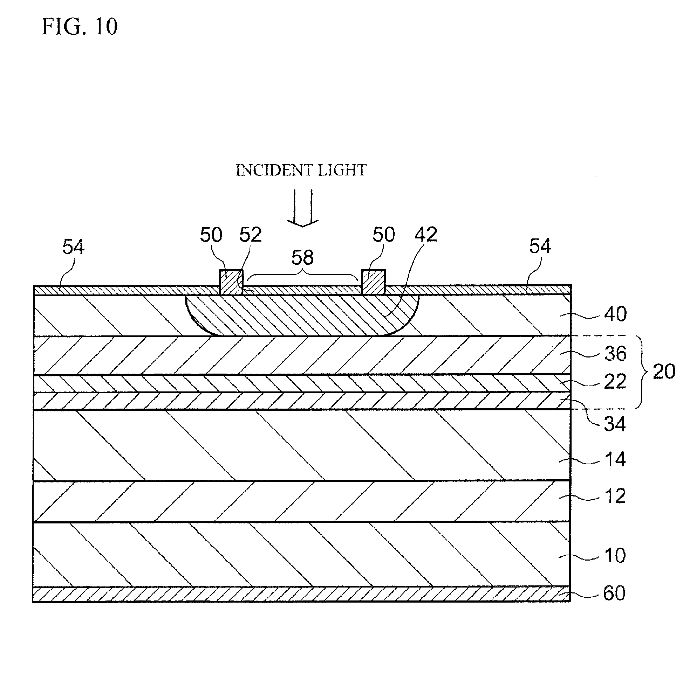

Fig. 10 is a cross-sectional view of a semiconductor light-receiving device in accordance with a fifth embodiment. The fifth embodiment does not have the electric field drop layer 32 of the fourth embodiment shown in Fig. 9. That is, the electric field drop occurs in the electric field drop layer 34 only. Thus, the maximum electric field intensity shown in Fig. 8B can be further reduced. Thus, the voltage applied across the pn junction can be further reduced for the same multiplication factor M.

[Sixth Embodiment]

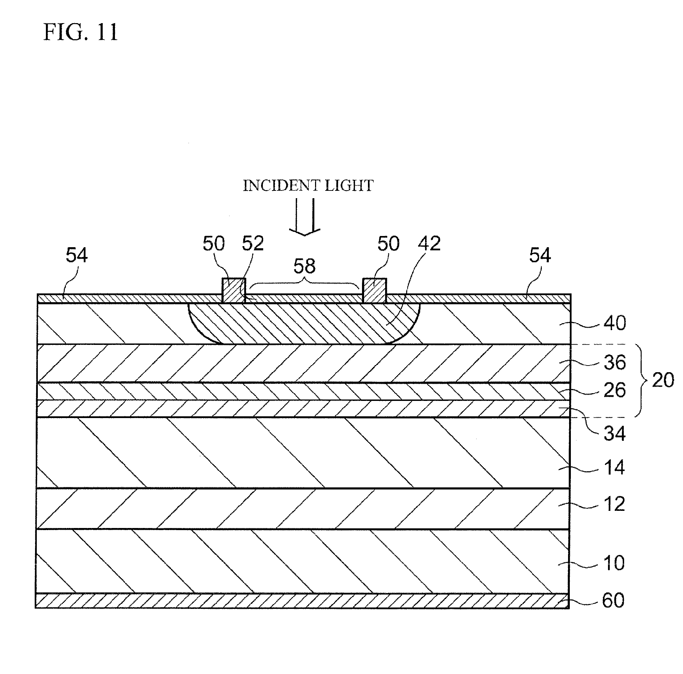

Fig. 11 is a cross-sectional view of a semiconductor light-receiving device in accordance with a sixth embodiment. The sixth embodiment varies the structure of the fifth embodiment shown in Fig. 10 so that the sixth embodiment employs a buffer layer 26 of n$^-$ type. The other structures of the sixth embodiment are the same as corresponding those of the fifth embodiment, and a description thereof will be omitted. According to the sixth embodiment, the buffer layer 26, which buffers the band gaps of the light absorption layer 14 made of InGaAs and the band gap of the p$^+$-type conduction region 42 made of InP, is used as an electric field drop layer having a dope concentration greater than that of the light absorption layer 14. Since the effective length of the multiplication region is increased, the voltage applied across the pn junction can be reduced like the third embodiment. The InGaAs electric field drop layer 32 may be omitted so that the buffer layer 22 is provided directly on the light absorption layer 14 and is caused to function as the electric field drop layer.

[Seventh Embodiment]

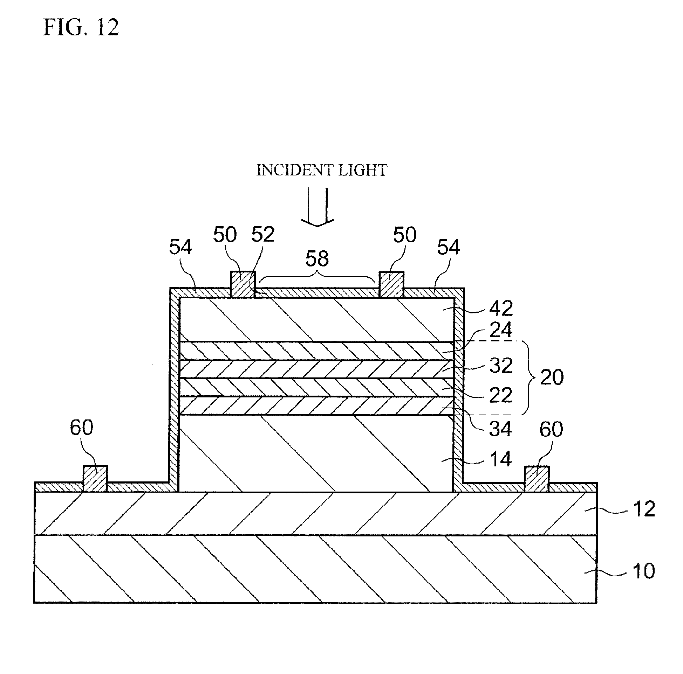

Fig. 12 is a cross-sectional view of a semiconductor light-receiving device in accordance with a seventh embodiment. The seventh embodiment differs from the third embodiment in that the seventh embodiment employs a semi-insulating InP substrate 10. Further, the p$^+$-type conduction region 42 of the seventh embodiment is not a diffused layer but an epitaxial layer. Mesa etching is performed until it reaches the n$^+$-type conduction layer 12, and the n-type contact electrode 60 is formed from the surface side (to which light is incident). The semiconductor light-receiving devices of the third through sixth embodiments may be of a mesa structure type like the seventh embodiment. The mesa type light-receiving structure may employ the diffusion junction or growth junction. The third through sixth embodiments may employ a p-type guard ring. The voltage applied across the pn junction can be reduced.

In the first through seventh embodiments, the first and second conduction types are respectively n and p types. Thus, the first conduction layer is the n$^+$-type conduction layer 12, and the second conduction region is the p$^+$-type conduction region 42. Alternatively, the first and second conduction types may be p and n types, respectively. In this case, the first conduction layer is the p$^+$-type conduction layer 12, and the second conduction region is an n$^+$-type conduction region.

The above-mentioned first through seventh embodiments are of a type in which light is incident to the front surface of the device. Alternatively, light may be incident to the backside or a side surface of the device. The first through seventh embodiments employ InP/InGaAs base semiconductor substances. However, the present invention is not limited to these semiconductor substances but may employ semiconductor substances that satisfy the relationship in size between the band gap of the multiplication layer 20 and that of the light absorption layer 14. For example, similar effects may be brought by GaAs/AlGaAs base semiconductor materials.

In the first through seventh embodiments, the $n^+$-type conduction layer 12 and the layer having the same band gap as that of the $n^+$-type conduction layer 12 may be made of InP, and the light absorption layer 14 and a layer having the same band gap as that of the light absorption layer 14 may be made of InGaAs. Thus, the devices of the first through seventh embodiments may be used as light-receiving devices in the optical fiber communication systems.

In the first through seventh embodiments, it is possible to obtain a multiplication factor M of 6 with a constant voltage equal to or lower than 20 V by the electric field drop layer 32 that is formed on the light absorption layer 14 and is doped with n-type impurities and that has a thickness of 0.1 $\mu$m or less and a carrier concentration of 4 x $10^{17}$ cm$^{-3}$.

In the first through seventh embodiments, it is possible to obtain a required multiplication and frequency response performance (the product of the multiplication and band width (MB product) ranges from 20 GHz to 130 GHz) in the optical fiber communication systems by setting the thickness of the undoped layer 24 to the range of 0.1 $\mu$m to 0.3 $\mu$m.

In the first through seventh embodiments, it is possible to obtain a required quantum efficiency of 60% to 95% in the optical fiber communication systems by setting the thickness of the undoped layer 24 to the range of 0.1 $\mu$m to 0.3 $\mu$m and by setting the carrier concentration undoped or equal to 1.5 x $10^{15}$ cm$^{-3}$ or less.

It is also possible to reduce the delay in carrier traveling caused by hetero barrier by the semiconductor light-receiving device having the buffer layer 22 provided as follows. The buffer layer 22 is provided above and close to the light absorption layer 14. The buffer layer 22 is doped with n-type impurities or is undoped. The buffer layer 22 has a band gap between the $n^+$-type conduction layer 12 and the light absorption layer 14. The buffer layer 22 has a thickness that ranges from 0.1 $\mu$m to 0.2 $\mu$m, and has an undoped carrier concentration or a carrier concentration of $3 \times 10^{15}$ cm$^{-3}$.

It is possible to cause multiplication and expand the effective multiplication region up to the buffer layer 26 and to reduce the voltage for multiplication by the semiconductor light-receiving device having the buffer layer 26 provided as follows. The electric field drop layer 32 is not employed and is provided above and close to the light absorption layer 14. The buffer layer 26 is doped with n-type impurities or undoped. The buffer layer 26 has a band gap between the $n^+$-type conduction layer 12 and the light absorption layer 14. The buffer layer 26 has a thickness that ranges from 0.1 $\mu$m to 0.2 $\mu$m, and is undoped or doped at a carrier concentration that ranges from 3 x $10^{15}$ cm$^{-3}$ to 3 x $10^{17}$ cm$^{-3}$.

The first through seventh embodiments may be used as light-receiving devices operable in a voltage environment equivalent to that of the PIN-PD (with a simple drive circuit).

As described above, the present invention has a simple structure without a guard ring and obtains a minimum required multiplication factor prior to the occurrence of the edge breakdown. According to an aspect of the present invention, there is provided a semiconductor light-receiving device including: a first conduction layer of a first conduction type; a light absorption layer provided on the first conduction layer; a multiplication layer provided on the light absorption layer; a window layer provided on the multiplication layer, the window layer being undoped or having the first conduction type; and a second conduction region provided in the window layer by impurity diffusion, the second conduction region having a band gap wider than that of the light absorption layer and having a second conduction type different from the first conduction type. The following condition is satisfied:

$$X/W \geq (M - 1)^2/(2M)$$

where W is a film thickness from a lower surface of the light absorption layer and an upper surface of the multiplication layer, X is a film thickness of the second conduction region, and M is a multiplication factor. A part of the light absorption layer is designed to have a high impurity concentration so that a graded carrier concentration region capable of not only absorbing light but also performing multiplication can be formed. It is thus possible to provide a less-expensive semiconductor light-receiving device that is suitably applied to optical communication systems required to have a high sensitivity that is not realized by the PIN-PD and has a multiplication factor as low as three times at a low power supply voltage (equal to or lower than 20 V) as used in the PIN-PD and a constant voltage drive (with a simple drive circuit).

The APD of the present invention may be applied to less-expensive subscriber systems without expensive design modification that may include the use of a high voltage power source and a bias voltage control apparatus. Thus, the APD of the present invention may provide great economic advantages.

The present invention is not limited to the specifically described embodiments, but other embodiments and variations may be made without departing from the scope of the present invention.

The present application is based on Japanese Patent Application No. 2006-141989 filed May 22, 2006, the entire disclosure of which is hereby incorporated by reference.

## Claims

1. A semiconductor light-receiving device comprising:

   a first conduction layer of a first conduction type;
   a light absorption layer provided on the first conduction layer;
   a multiplication layer provided on the light absorption layer;
   a window layer provided on the multiplication layer, the window layer being undoped or having the first conduction type; and
   a second conduction region provided in the window layer by impurity diffusion, the second conduction region having a band gap wider than that of the light absorption layer and having a second conduction type different from the first conduction type,
   the following condition being satisfied:

   $$X/W \geq (M - 1)^2/(2M)$$

   where W is a film thickness from a lower surface of the light absorption layer and an upper surface of the multiplication layer, X is a film thickness of the second conduction region, and M is a multiplication factor.

2. The semiconductor light-receiving device as claimed in claim 1, wherein the second conduction region has a peripheral portion having a curvature radius approximately equal to the film thickness of the second conduction region.

3. The semiconductor light-receiving device as claimed in claim 1, wherein the multiplication factor M is equal to or smaller than 6.

4. The semiconductor light-receiving device as claimed in claim 1, wherein the multiplication factor M is equal to or greater than 6.

5. The semiconductor light-receiving device as claimed in claim 1, wherein the peripheral portion of the second conduction region has a thinner thickness outwards.

6. The semiconductor light-receiving device as claimed in claim 1, wherein the multiplication layer includes a dope layer that contacts the second conduction region and has a dope concentration higher than that of the light absorption layer.

7. The semiconductor light-receiving device as claimed in claim 6, wherein the dope layer of the first conduction type has a thickness that ranges from 0.1 $\mu$m to 0.3 $\mu$m and a carrier concentration that ranges from 5 x $10^{15}$ cm$^{-3}$ and 5 x $10^{16}$ cm$^{-3}$.

8. The semiconductor light-receiving device as claimed in claim 1, wherein:

   the multiplication layer includes an electric field drop layer of the first conduction type;
   the electric field drop layer contacts the light absorption layer and has a band gap narrower than that of the second conduction region; and
   the electric field droop layer has a dope concentration higher than that of the light absorption layer.

9. The semiconductor light-receiving device as claimed in claim 1, wherein a region from an upper surface of the first conduction layer to a lower surface of the second conduction region is depleted.

10. The semiconductor light-receiving device as claimed in claim 1, wherein the window layer has a thickness in the range of 0.8 $\mu$m to 6.4 $\mu$m, and an undoped carrier concentration or a carrier concentration equal to or less than 3 x $10^{15}$ cm$^{-3}$.

11. A semiconductor light-receiving device comprising:

   a first conduction layer of a first conduction type;

a light absorption layer provided on the first conduction layer;

a multiplication layer provided on the light absorption layer;

a window layer provided on the multiplication layer, the window layer being undoped or having the first conduction type; and

a second conduction region provided in the window layer by impurity diffusion, the second conduction region having a band gap wider than that of the light absorption layer and having a second conduction type different from the first conduction type,

the multiplication layer having an electric field drop layer that contacts the light absorption layer and has a band gap narrower than that of the second conduction region,

the electric field drop layer having a cope concentration higher than that of the light absorption layer.

12. The semiconductor light-receiving device as claimed in claim 11, wherein the multiplication layer has a dope layer that contacts the second conduction region and has a dope concentration higher than that of the light absorption layer.

13. The semiconductor light-receiving device as claimed in claim 11, wherein the electric field drop layer has a buffer layer that buffers band gaps of the light absorption layer and the second conduction region.

14. The semiconductor light-receiving device as claimed in claim 11, wherein the multiplication layer has an upper electric field layer that is provided above the electric filed drop layer through a layer having a lower dope concentration than the electric field drop layer and has a higher cope concentration than the light absorption layer.

15. The semiconductor light-receiving device as claimed in claim 11, wherein the electric field drop layer has a thickness in the range of 0.1 $\mu$m to 0.3 $\mu$m, and a carrier concentration of 5 x $10^{15}$ cm$^{-3}$ and 5 x $10^{16}$ cm$^{-3}$ .

16. The semiconductor light-receiving device as claimed in claim 11, wherein the semiconductor light-receiving device operates at a voltage equal to or lower than 20 V.

17. The semiconductor light-receiving device as claimed in claim 11, wherein the semiconductor light-receiving device has a multiplication factor of 6 or smaller.

18. The semiconductor light-receiving device as claimed in claim 11, wherein the semiconductor light-receiving device operates at a constant voltage.

FIG. 1

FIG. 2

FIG. 3

FIG. 4

INCIDENT LIGHT

FIG. 5

P TYPE DOPE CONCENTRATION OF P-TYPE CONDUCTION REGION

DOPE CONCENTRATION OF DOPE LAYER IN SECOND EMBODIMENT

DOPE CONCENTRATION OF WINDOW LAYER IN FIRST EMBODIMENT

DOPE CONCENTRATION

FRONT SURFACE                    DEPTH

FIG. 6

INCIDENT LIGHT

FIG. 7A

FIG. 7B

FIG. 8A

FIG. 8B

FIG. 9

INCIDENT LIGHT

FIG. 10

INCIDENT LIGHT

FIG. 11

INCIDENT LIGHT

FIG. 12

INCIDENT LIGHT

**European Patent Office**

# EUROPEAN SEARCH REPORT

Application Number

EP 07 10 8665

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 4 587 544 A (WEBB PAUL P [CA]) 6 May 1986 (1986-05-06) | 1-6,9,10 | INV. H01L31/0304 H01L31/0352 H01L31/107 |
| Y | * the whole document * | 7,8 | |
| X | WO 03/065417 A (PICOMETRIX INC [US]; KO CHENG C [US]) 7 August 2003 (2003-08-07) | 11,13, 14,16-18 | |
| Y | * abstract; figures 1,2 * | 7,8 | |
| X | JP 01 261874 A (HITACHI LTD) 18 October 1989 (1989-10-18)  * abstract; figures 1,3,4 * * page 376 * | 1-3, 6-12, 15-18 | |
| X | WATANABE I ET AL: "IMPACT IONIZATION RATES IN (100) AL0.48IN0.52AS" IEEE ELECTRON DEVICE LETTERS, IEEE SERVICE CENTER, NEW YORK, NY, US, vol. 11, no. 10, 1 October 1990 (1990-10-01), pages 437-438, XP000148546 ISSN: 0741-3106 * abstract; figure 1 * | 1 | |
| X | JP 10 065202 A (HYUNDAI ELECTRONICS IND) 6 March 1998 (1998-03-06) | 1,5,9 | |
| Y | * abstract; figures 7-9 * | 13 | |
| X | JP 03 255676 A (MITSUBISHI ELECTRIC CORP) 14 November 1991 (1991-11-14) * abstract; figure 1 * | 1,9 | |
| X | US 2004/245592 A1 (HARMON ERIC S [US] ET AL) 9 December 2004 (2004-12-09) * abstract; figures 4,7,9 * | 11 | |

**TECHNICAL FIELDS SEARCHED (IPC)**

H01L

-/--

The present search report has been drawn up for all claims

| Place of search | Date of completion of the search | Examiner |
|---|---|---|
| The Hague | 14 September 2007 | Heising, Stephan |

**European Patent Office**

**EUROPEAN SEARCH REPORT**

Application Number

EP 07 10 8665

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2006/001118 A1 (BOISVERT JOSEPH C [US] ET AL) 5 January 2006 (2006-01-05) * abstract; figures 1,2 * | 11-13, 16-18 | |
| Y | US 2003/111675 A1 (YAO JIE [US]) 19 June 2003 (2003-06-19) * abstract; figure 2 * | 13 | |
| P,X | US 2007/085158 A1 (ITZLER MARK A [US] ET AL) 19 April 2007 (2007-04-19) * abstract; figures 1,2,6 * | 1,11 | |
| A | JP 62 033482 A (MITSUBISHI ELECTRIC CORP) 13 February 1987 (1987-02-13) * abstract; figures 1,3 * | 1 | |
| A | EP 0 325 532 A2 (FUJITSU LTD [JP]) 26 July 1989 (1989-07-26) * abstract; figure 5 * | 1-18 | |
| A | US 6 515 315 B1 (ITZLER MARK A [US] ET AL) 4 February 2003 (2003-02-04) | 1-18 | TECHNICAL FIELDS SEARCHED (IPC) |
| A | US 4 083 062 A (OHUCHI HIROBUMI ET AL) 4 April 1978 (1978-04-04) | 1-18 | |
| A | US 5 654 578 A (WATANABE ISAO [JP]) 5 August 1997 (1997-08-05) * abstract; figures 1,3,4,7 * | 1-18 | |

The present search report has been drawn up for all claims

| Place of search | Date of completion of the search | Examiner |
|---|---|---|
| The Hague | 14 September 2007 | Heising, Stephan |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

European Patent
Office

## CLAIMS INCURRING FEES

The present European patent application comprised at the time of filing more than ten claims.

☐ Only part of the claims have been paid within the prescribed time limit. The present European search report has been drawn up for the first ten claims and for those claims for which claims fees have been paid, namely claim(s):

☐ No claims fees have been paid within the prescribed time limit. The present European search report has been drawn up for the first ten claims.

## LACK OF UNITY OF INVENTION

The Search Division considers that the present European patent application does not comply with the requirements of unity of invention and relates to several inventions or groups of inventions, namely:

see sheet B

☐ All further search fees have been paid within the fixed time limit. The present European search report has been drawn up for all claims.

☒ As all searchable claims could be searched without effort justifying an additional fee, the Search Division did not invite payment of any additional fee.

☐ Only part of the further search fees have been paid within the fixed time limit. The present European search report has been drawn up for those parts of the European patent application which relate to the inventions in respect of which search fees have been paid, namely claims:

☐ None of the further search fees have been paid within the fixed time limit. The present European search report has been drawn up for those parts of the European patent application which relate to the invention first mentioned in the claims, namely claims:

**European Patent Office**

**LACK OF UNITY OF INVENTION SHEET B**

Application Number

EP 07 10 8665

The Search Division considers that the present European patent application does not comply with the requirements of unity of invention and relates to several inventions or groups of inventions, namely:

    1. claims: 1-10

            high curvature radius of second conduction region
                            ---

    2. claims: 11-18

            Field drop layer between light absorption layer and
            multiplication layer
                            ---

## ANNEX TO THE EUROPEAN SEARCH REPORT
## ON EUROPEAN PATENT APPLICATION NO.

EP 07 10 8665

This annex lists the patent family members relating to the patent documents cited in the above-mentioned European search report.
The members are as contained in the European Patent Office EDP file on
The European Patent Office is in no way liable for these particulars which are merely given for the purpose of information.

14-09-2007

| Patent document cited in search report | | Publication date | Patent family member(s) | | Publication date |
|---|---|---|---|---|---|
| US 4587544 | A | 06-05-1986 | CA | 1228661 A1 | 27-10-1987 |
| WO 03065417 | A | 07-08-2003 | CA | 2473223 A1 | 07-08-2003 |
| | | | CN | 1633699 A | 29-06-2005 |
| | | | EP | 1470572 A2 | 27-10-2004 |
| | | | JP | 2005516414 T | 02-06-2005 |
| JP 1261874 | A | 18-10-1989 | NONE | | |
| JP 10065202 | A | 06-03-1998 | JP | 2936539 B2 | 23-08-1999 |
| JP 3255676 | A | 14-11-1991 | NONE | | |
| US 2004245592 | A1 | 09-12-2004 | NONE | | |
| US 2006001118 | A1 | 05-01-2006 | NONE | | |
| US 2003111675 | A1 | 19-06-2003 | US | 2005017317 A1 | 27-01-2005 |
| US 2007085158 | A1 | 19-04-2007 | NONE | | |
| JP 62033482 | A | 13-02-1987 | NONE | | |
| EP 0325532 | A2 | 26-07-1989 | DE | 68922117 D1 | 18-05-1995 |
| | | | DE | 68922117 T2 | 24-08-1995 |
| | | | JP | 1183174 A | 20-07-1989 |
| | | | US | 4984032 A | 08-01-1991 |
| US 6515315 | B1 | 04-02-2003 | NONE | | |
| US 4083062 | A | 04-04-1978 | DE | 2707180 A1 | 01-09-1977 |
| | | | JP | 52101990 A | 26-08-1977 |
| US 5654578 | A | 05-08-1997 | JP | 2601231 B2 | 16-04-1997 |
| | | | JP | 8181349 A | 12-07-1996 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 5021830 A
- JP 2006141989 A